# EUROPEAN PATENT APPLICATION

(11) **EP 4 815 713 A2**
(43) Date of publication of application: **30.09.2026**
(21) Application number: 25221029.9
(22) Date of filing: 05.12.2025
(51) Int. Cl.: H10W 42/00, H10W 70/09, H10W 74/15, H10W 90/10

(54) **METHODS OF FORMING BRIDGE CHIPLET SHIELD STRUCTURES**

(30) Priority: 28.03.2025 US 202519094406
(71) Applicant: INTEL Corporation, Santa Clara, CA 95054 (US)
(72) Inventor: COLLINS, Andrew, Chandler, 85249 (US)
(74) Representative: Viering, Jentschura & Partner mbB Patent- und Rechtsanwälte

(57) **Abstract**

Microelectronic integrated circuit package structures include a substrate comprising an IC die on a surface of the substrate, where a first edge of a bridge die is below a portion of the IC die and is embedded within the substrate. The bridge die is coupled to the IC die, and a dummy die is adjacent to the IC die on the substrate, where a second edge of the bridge die is below the dummy die.

## Description

### BACKGROUND

In electronics manufacturing, integrated circuit (IC) packaging is a stage of manufacture where an IC that has been fabricated on a die or chip comprising a semiconducting material is coupled to a supporting case or "package" that can protect the IC from physical damage and support electrical interconnect suitable for further connecting to a host component, such as a printed circuit board (PCB). In the IC industry, the process of fabricating a package is often referred to as packaging, or assembly.

Advanced 2.5-3D packaging architectures may include bridge die structures which may be re-used. The use and re-use of bridge die structures may present a challenge in that the employment of various package architectures may be limited in their use, due to bridge structure failures. Certain advanced packaging configurations which may rely on bridge chiplet structures may be hindered in the maximization of re-use of bridge chiplet structures for various die-to-die interfaces across a disaggregated die complex within a package design and across package design skews. For example, some die complexes have instances where a re-used bridge die may be susceptible to stress point creation within a very thin bridge chiplet. This is a significant risk for induced bridge die cracking failures.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIGS. 1A-1B is a cross-sectional view of a package structure comprising a bridge die shielding structure, in accordance with some embodiments.
FIGS. 1C-1E are top views of a package structure comprising a bridge die shielding structure, in accordance with some embodiments.
FIGS. 2A-2C are cross-sectional views of methods of forming a package structure comprising a bridge die shielding structure, in accordance with some embodiments.
FIG. 3 is a cross-sectional view of an IC package structure comprising a bridge die shielding structure, in accordance with some embodiments.
FIG. 4 illustrates a flow chart of processes for the fabrication of a package structure comprising a bridge die shielding structure, in accordance with some embodiments.
FIG. 5 is a functional block diagram of an electronic computing device, in accordance with some embodiments of the present disclosure.

### DETAILED DESCRIPTION\

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the explicit context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent.

The term "package" generally refers to a self-contained carrier of one or more dice, where the dice are attached to the package substrate, and may be encapsulated for protection, with integrated or wire-bonded interconnects between the dice and leads, pins or bumps located on the external portions of the package substrate. The package may contain a single die, or multiple dice, providing a specific function. The package is usually mounted on a printed circuit board for interconnection with other packaged integrated circuits and discrete components, forming a larger circuit.

The term "dielectric" generally refers to any number of non-electrically conductive materials that make up the structure of a package substrate.

The term "metallization" generally refers to metal layers formed over and through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and carries the same meaning.

The term "solder bump" generally refers to a solder layer formed on a bond pad. The solder layer typically has a round shape, hence the term "solder bump".

The term "substrate" generally refers to a planar platform comprising dielectric and metallization structures. The substrate mechanically supports and electrically couples one or more IC dies on a single platform, with encapsulation of the one or more IC dies by a moldable dielectric material. The substrate generally comprises solder bumps as bonding interconnects on both sides. One side of the substrate, generally referred to as the "die side", comprises solder bumps for chip or die bonding. The opposite side of the substrate, generally referred to as the "land side", comprises solder bumps for bonding the package to a printed circuit board.

The vertical orientation is in the z-direction and it is understood that recitations of "top", "bottom", "above" and "below" refer to relative positions in the z-dimension with the usual meaning. However, it is understood that embodiments are not necessarily limited to the orientations or configurations illustrated in the figure.

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

Views labeled "cross-sectional", "profile" and "plan" correspond to orthogonal planes within a Cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure.

Embodiments discussed herein address problems associated with manufacturing 2.5D-3D packages where advanced packaging structures employ re-used bridge chiplet structures for various die-to-die interfaces, including disaggregated die complexes within a package design and across package design skews. In some cases, die complexes may possess a re-used embedded bridge die extending outside of a surface mount die complex area, for example. This situation could create a stress point within the bridge chiplet structure, which in some instances may be very thin. Because of the stress induced within the bridge structure, a significant risk exists in terms of bridge chiplet structural reliability.

The package structures described in the embodiments herein include a chiplet shield structure, such as a dummy die (which may comprise a glass or a silicon material) with a CTE (co-efficient of thermal expansion) close to the bridge material, which pushes out a high stress point to a location outside of the bridge shadow. The chiplet shield structure may be employed at a low cost and enables great flexibility for re-use of the embedded bridge chiplet structures. In an embodiment, an embedded bridge chiplet may extend beyond a surface mount die complex shadow according to a particular package architecture design requirement, such as in an advanced packaging die complex. A surface mount integrated circuit (IC) die underfill fillet may create a coefficient of thermal expansion (CTE) stress point that propagates into the embedded bridge.

By using a dummy bridge shield chiplet placed adjacent to the IC die, the dummy die extends the high stress point beyond the re-used bridge chiplet shadow. The use of a dummy die to shift the stress point away from the bridge die to avoid stress failures in the bridge die may be employed within any advanced package architecture such as ball grid array, fan-out embedded bridge designs, integrated fan out designs, or chip on wafer on substrate designs. The use of the bridge shield chiplet dummy die enables bridge re-use with minimal mechanical risk.

The architectures described herein may be assembled and/or fabricated with one or more of the features or attributes provided in accordance with various embodiments. A number of different assembly and/or fabrication methods may be practiced to enable the formation of disaggregated package substrate structures which reduce cost and increase design flexibility during processing, according to one or more of the features or attributes described herein.

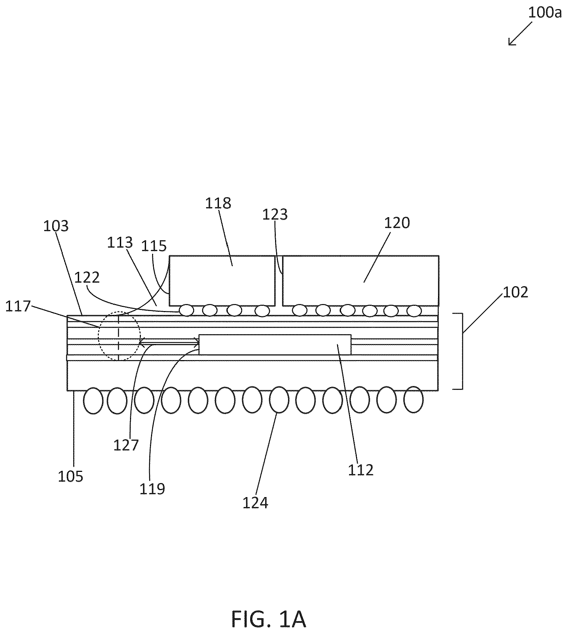

FIGS. 1A-1B illustrate embodiments of a package structure 100 comprising a dummy die which shields an embedded bridge die from stress damage and/or failure. The package structures herein may be formed utilizing standard IC processing techniques. The methods of fabrication described herein create improved device performance in advanced 2.5D and 3D packaging.

FIG. 1A is a cross-sectional view of a portion of a package structure 100a according to an embodiment. In an embodiment, the package structure 100 may comprise a multi-chip package structure 100. In an embodiment, the package structure may comprise a substrate 102, which may comprise a portion of any suitable package architecture, such as a ball grid array (BGA) substrate 102, for example. In an embodiment, the substrate 102 may comprise a dielectric material with conductive traces dispersed within the dielectric material according to the particular design requirements. In an embodiment, the substrate 102 may comprise an organic material, or it may comprise a layer of glass in an embodiment.

In an embodiment, the substrate 102 may include electrical elements, such as resistors, capacitors, signal distribution circuitry, combinations of these or the like. These electrical elements may be active, passive, or a combination thereof. In other embodiments, the substrate 102 is free from both active and passive electrical elements therein. The substrate 102 may comprise a first side 103 and a second side 105.

An integrated circuit (IC) die 120 may be directly on the first side 103 of the substrate 102. In an embodiment, any number of IC dies may be on the first side of the substrate 102. In an embodiment, the IC die 120 may comprise any number of functionalities, or may be designed and manufactured to serve a variety of functions that are optimal for their location within the package structure 100, such as a central processing unit (CPU) die, a logic die, or a memory die for example.

In an embodiment, the IC die 120 may be coupled to the first side 103 of the substrate 102 by interconnects structures 122. The interconnect structures 122 may comprise conductive bumps or may be any other type of electrical connection in addition to or instead of the bumps shown (e.g., balls, pins, pads, wire bonding, etc., and may directly couple the IC die 120 to the first side 103 of the substrate 102.

The IC die 120 may be manufactured separately from a wafer/panel processing. In an embodiment, the IC die 120 may include an active die comprising silicon processing for input/output (I/O) interface capabilities such as a universal chiplet interconnect express (UCIe) IC die, or a power management IC (PMIC), or a memory die. Another functionality of the IC die 120 may include integrated passive devices such as capacitive, inductive or resistive device elements for use with a power delivery network.

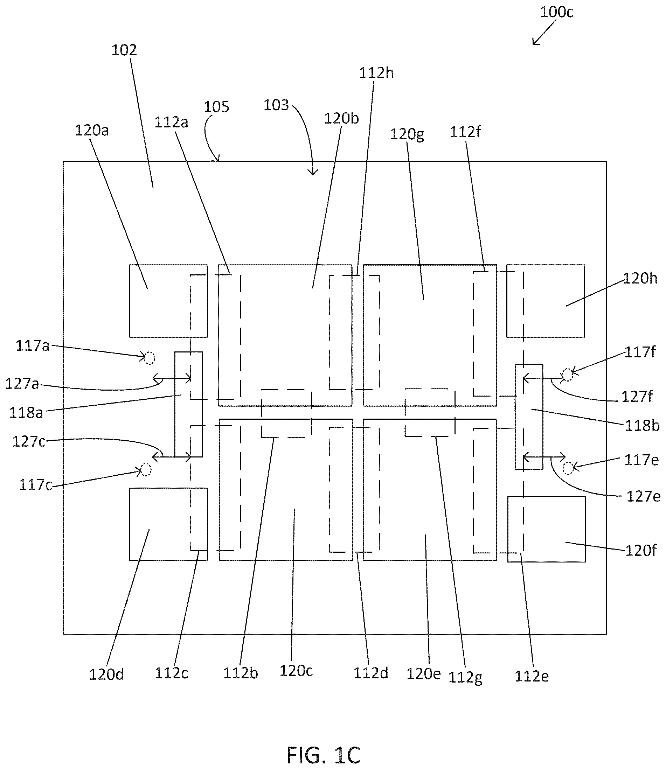

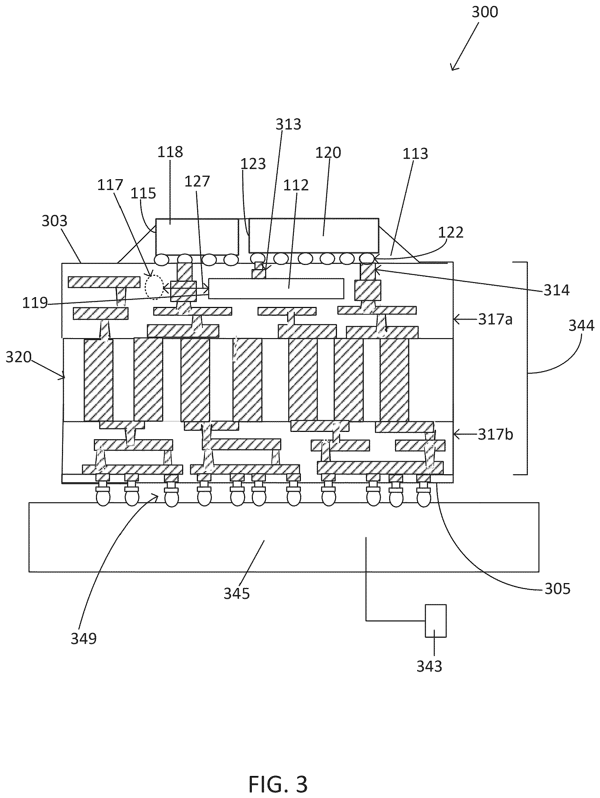

In an embodiment, the IC die 120 may be electrically and mechanically coupled to a bridge die 112, which may be embedded within a portion of the substrate 102. In an embodiment, the bridge die 112 may comprise an organic interconnect bridge, or may comprise any suitable material such as silicon. In an embodiment, the bridge die 112 may comprise redistribution interconnect structures. In an embodiment, the bridge die 112 may comprise a silicon interconnect bridge that provides electrical connections between the IC die 120 and an additional IC die (such as those shown on FIGS.1C-1E for example) that may be adjacent the IC die 120 on the substrate 102. In an embodiment, the bridge die 112 may comprise a high density die-to-die interconnect structure with or without vertical through silicon vias (TSVs) to include power delivery or signal interconnect to the substrate 102. In an embodiment, the IC die 120 may be coupled to the bridge die 112 with bridge interconnect structures 313, as depicted in FIG. 3 for example.

In an embodiment, an edge 119 of the bridge die 112 may extend beyond an edge 123 of the IC die 120. In an embodiment, a dummy die 118 may comprise dummy silicon block with a low coefficient of thermal expansion (CTE) filler material to improve mechanical performance and reliability of the package structure/module 100. The dummy die 118 may be placed on the first side 103 of the substrate 102 adjacent to the IC die 120.

In an embodiment, an edge 115 of the dummy die 118 extends a distance 127 beyond an edge 119 of the bridge die 112. In an embodiment, the distance 127 is greater than 0.5 microns. In an embodiment, the distance 127 is greater than a distance between the edge 119 of the bridge die 112 and the edge 115 of the dummy die 118. A stress region 117 extends the distance 127 beyond the edge 119 of the bridge die 112. In an embodiment, the stress region 117 may comprise a high stress region, and may comprise a stress on the order of 1-10 MPa, and will generally be significantly larger than a stress at the bridge die 112. In an embodiment, the stress region 117 may comprise a stress that is greater than 10 times the stress at the edge 119 of the bridge die 112. In another embodiment, the stress region 117 may comprise a stress that is greater than 100 times the stress at the edge 119 of the bridge die 112. By placing the dummy die 118 in a location that is optimized for stress reduction within the package structure 100a, adjacent to the edge 123 of the IC die 120, the edge 115 of the dummy die 118 extends beyond the edge 119 of the bridge die 112, thus shifting the stress point 117 away from the edge 119 of the bridge die 112. The dummy die 118 prevents the cracking of the bridge die 112, which can be very thin, within the package structure 100, and consequently improves the reliability of the bridge die 112 and the package structure 100 as a whole.

An underfill material 113 may be on the sides of the dummy die 118 and may surround conductive bumps 122. In an embodiment, solder bumps 124 may be on a second side 105 of the substrate 102. In an embodiment, a top surface of the dummy die 118 may be coplanar with top surfaces of the IC die 120.

In an embodiment, the underfill material 113 may be between the IC die 120 and the dummy die 118 and may be between adjacent IC dies 120 that may be adjacent to each other on the substrate 102. The underfill material 113 may be adjacent the dummy die 118 and the IC die 120. The underfill material 113 may comprise an epoxy material in an embodiment and may be on surfaces of the dummy die 112 and on surfaces of the IC die 120. In an embodiment, the IC die 120 may comprise a surface mount die, where the underfill material 113 may create a CTE stress point, due to the differences between the CTE of the underfill material 113 and the material of the bridge die 112. The difference between the CTE's of the underfill material 113 and the bridge die 112 material may cause the embedded bridge die 112 to crack. The dummy die 118 extends the high stress point 117 beyond the bridge die 112 shadow.

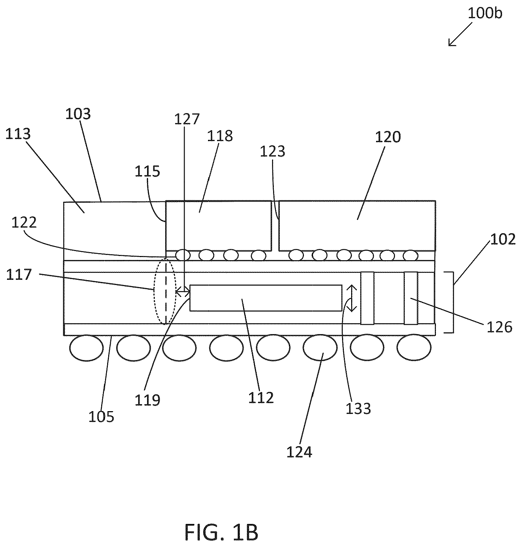

In FIG. 1B, a cross-sectional view of a package structure 100b is depicted, according to an embodiment. In an embodiment, the package structure 100b may comprise a multi-chip package structure 100b. In an embodiment, the package structure 100b may comprise a fan out embedded bridge package structure. In an embodiment, the package structure 100b may comprise a substrate 102, which may comprise dielectric material with conductive traces dispersed within the dielectric material according to the particular design requirements. The substrate 102 may comprise a first side 103 and a second side 105. In an embodiment via structures 126 may extend through the substrate 102.

An integrated circuit (IC) die 120 may be directly on the first side 103 of the substrate 102. In an embodiment, any number of IC dies may be on the first side of the substrate 102. Interconnect structures 122 couple to the IC die 120 to the first side 103 of the substrate 102.

In an embodiment, the IC dies 120 may be electrically and mechanically coupled to a bridge die 112. In an embodiment, the bridge die 112 may comprise a silicon interconnect bridge that provides electrical connections between the IC die 120 and an additional IC die (such as those shown on FIGS.1C-1E for example) that may be adjacent the IC die 120 on the substrate 102. The bridge die 112 is embedded within the substrate 102. In an embodiment, the bridge die 112 may comprise a glass or a silicon material. In an embodiment the bridge die 112 may comprise a thickness 133 of between 30 to 60 microns.

In an embodiment, an edge 119 of the bridge 112 may extend beyond an edge 123 of the IC die 120. The dummy die 118 may be placed on the first side 103 of the substrate 102 adjacent to the IC die 120. In an embodiment, an edge 115 of the dummy die 118 extends a distance 127 beyond the edge 119 of the bridge die 112. A stress region 117 extends a distance beyond the edge 119 of the bridge die 112. By placing the dummy die 118 adjacent to the edge 123 of the IC die 120, the edge 115 of the dummy die 118 extends beyond the edge 119 of the bridge die 112, thus shifting the stress point 117 away from the edge 119 of the bridge die 112. In an embodiment, the stress region 117 is below the edge 115 of the dummy die 118.

An underfill material 113 may be on the sides of the dummy die 110 and may surround conductive bumps 122. In an embodiment, solder bumps 124 may be on the second side 105 of the substrate 102. In an embodiment, the underfill material 113 may be between the IC die 120 and the dummy die 118 and may be between adjacent IC dies 120 that may be adjacent to each other on the substrate 102. The underfill material 113 may be adjacent the edges of the dummy die 118 and the IC die 120. The underfill material 113 may comprise an epoxy material in an embodiment and may be on surfaces of the dummy die 112 and on surfaces of the IC die 120.

In an embodiment, the IC die 120 may comprise a surface mount die, where the underfill material 113 may create a coefficient of thermal expansion (CTE) stress point, due to the differences between the CTE of the underfill material 120 and the silicon material of the bridge die 112, for example. In an embodiment, the dummy bridge shield 118 is placed on the substrate 102 adjacent to the IC die 120 to extend the high stress point 117 beyond the re-used bridge 112 shadow in a die complex.

In FIG. 1C, a top view of a package structure 100c is depicted, according to an embodiment. In an embodiment, the package structure 100c may comprise a multi-chip package structure 100. In an embodiment, the package structure 100b may comprise any suitable package architecture, such as a fan-out embedded bridge designs, an integrated fan out design, or a chip on wafer on substrate design architecture. In an embodiment, the package structure may comprise a substrate 102, which may comprise dielectric material with conductive traces. The substrate 102 may comprise a first side 103 and a second side 105. In an embodiment, IC dies 120a-120h are adjacent to each other on the first side 103 of the substrate 102.

In an embodiment, an IC die 120a may be electrically and mechanically coupled to a bridge die 112a. In an embodiment, the bridge die 112a may comprise a silicon interconnect bridge that provides electrical connections between the IC dies 120a and IC die 120b that are adjacent to each other on the substrate 102. The bridge die 112a is embedded within the substrate 102. A first dummy die 118a may be adjacent to an edge of IC die 120a and may be adjacent to an edge of IC die 120b. In an embodiment, an edge of the IC die 120a may be at right angles to an edge of the IC die 120b.

An IC die 120c may be below the IC die 120b. A second bridge die 112b may couple the IC dies 120c to IC die 120b. The first dummy die 118a may be adjacent an edge of the IC die 120a and adjacent an edge of the IC die 120c. The edge of the IC die 120a and the edge of the IC die 120c may be parallel to each other. In an embodiment, a third bridge die 112c couples the IC dies 120a and an IC die 120d. The first dummy die 118a may be over a portion of the first bridge die 112a and over a portion of the third bridge die 112c.

A fourth bridge die 112d may couple IC die 120c and IC die 120e. IC dies 120c, 120e are adjacent to each other on the first side 103 of the substrate 102. A fifth bridge die 112e may couple the IC die 120e to an IC die 120f. The fifth bridge die 112e may extend beyond the edges of the IC dies 120e, 120f. At least one of the edges of the IC dies 120e, 120f are perpendicular to each other, and at least one of the edges of the IC dies 120e, 120f are parallel to each other. A second dummy die 118b may be adjacent to the edges of the IC die 120e and adjacent to the edges of the IC die 120f. A portion of the second dummy die 118b may be over a portion of the fifth bridge die 112e and over a portion of a sixth bridge die 112f, wherein the sixth bridge die 112f couples an IC die 120g with an adjacent IC die 120h. A bridge die 112g may couple IC dies 120g, 120e and a bridge die 112h my couple IC dies 120b, 120g.

In an embodiment, IC dies 120b, 120g may be over IC dies 120c, 120e, wherein the IC dies 120b, 120g, 120c, 120e comprise a rectangular pattern. Dummy die 118a extends stress regions 117a, 117c a distance 127a, 127c beyond edges of the bridge dies 112a, 112c. The stress regions 117a, 117c may be any shape and the distances 127a, 127c may vary according to the particular architectural design requirements. In an embodiment, dummy die 118b extends stress regions 117e, 117f a distance 127e, 127f beyond edges of the bridge dies 112e, 112f. By placing the dummy dies 118a, 118b adjacent to the edges of the IC dies 120b, 120c and IC dies 120e, 120g respectively, the reliability of the bridge dies 112a, 112c and bridge dies 112e, 112f is improved.

An underfill material may be on the sidewalls of the dummy dies 118a, 118b. In an embodiment, top surfaces of the dummy dies 118a, 118b may be coplanar with top surfaces of the IC dies 120a-120h. The underfill material may comprise an epoxy material in an embodiment and may be on surfaces of the dummy dies 118a, 118b and on surfaces of the IC die 120. The dummy dies 118a, 118b benefit most die complexes thermally due to the larger silicon to thermal heat synch contact area, in an embodiment.

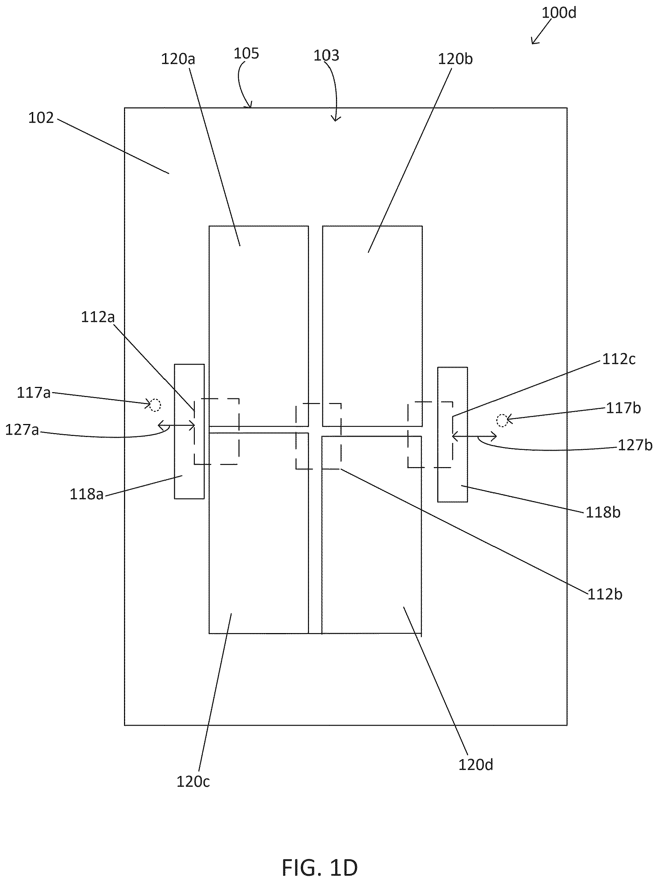

In FIG. 1D, a top view of a package structure 100d is depicted, according to an embodiment. In an embodiment, the package structure 100d may comprise a multi-chip package structure 100. In an embodiment, the package structure 100b may comprise a ball grid array, fan-out embedded bridge designs, integrated fan out designs, or chip on wafer on substrate die complex architecture. In an embodiment, the package structure 100d may comprise a substrate 102, which may comprise dielectric material with conductive traces dispersed within the dielectric material with a first side 103 and a second side 105. In an embodiment, IC dies 120a-120d are adjacent to each other on the first side 103 of the substrate 102. In an embodiment, the IC dies 120a-120d are arranged in a rectangular pattern, wherein a first bridge die 112a couples IC dies 120a, 120c to each other, and a second bridge die 112b couples IC dies 120a, 120b ,120c, 120d together. A third bridge die 112c couples IC dies 120b, 120d together.

In an embodiment, the IC dies 120a-120d may be electrically and mechanically coupled to the bridge die 112b. In an embodiment, the bridge dies 112a, 112b, 112c may comprise a silicon interconnect bridge that provides electrical connections between the IC dies 120a, 120b, 120c, 120db that are adjacent to each other on the substrate 102. The bridge dies 112a-120d are embedded within the substrate 102.

Dummy die 118a extends stress region 117a a distance 127a, beyond edges of the bridge die 112a. In an embodiment, dummy die 118b extends stress region 117b a distance 127b beyond edges of the bridge die 112c. The stress regions 117a, 117c may be any shape and the distances 127a, 127c may vary according to the particular architectural design requirements. By placing the dummy dies 118a, 118b adjacent to the edges of the IC dies 120a- 120d, the reliability of the bridge dies 112a, 112c is improved.

An underfill material (as shown in FIGS. 1A-1B) may be between and on top surfaces of the dummy dies 118a, b and may be between and on top surfaces of the IC dies 12a-120d. The underfill material 1may comprise an epoxy material in an embodiment.

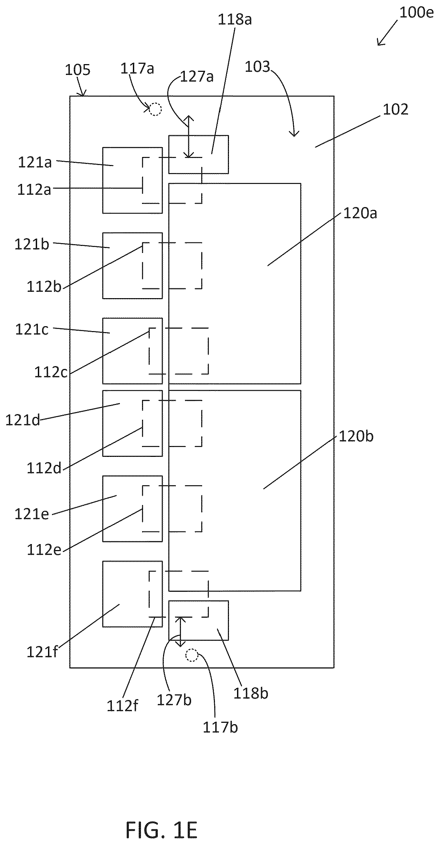

In FIG. 1E, a top view of a package structure 100e is depicted, according to an embodiment. In an embodiment, the package structure 100e may comprise a multi-chip package structure 100. In an embodiment, the package structure 100e may comprise a ball grid array, fan-out embedded bridge designs, integrated fan out designs, or chip on wafer on substrate die complex architecture. In an embodiment, the package structure 100e may comprise a substrate 102, which may comprise dielectric material with conductive traces dispersed within the dielectric material according to the particular design requirements. The substrate 102 may comprise a first side 103 and a second side 105.

In an embodiment, first and second IC dies 120a,120b are adjacent to each other on the first side 103 of the substrate 102. In an embodiment, the first IC die 120a may be above the second IC die 120b, wherein memory dies 121a-121c may be coupled to the first IC die 120a by bridge dies 112a-112c respectively. In an embodiment, memory dies 121d-121f may be coupled to the second IC die 120b by bridge dies 112d-112f respectively. In an embodiment, the first and second IC dies 120a, 120b are not memory dies.

In an embodiment, the IC dies 120a, 12b may be electrically and mechanically coupled to the bridge dies 112a-120f. In an embodiment, the bridge dies 112a-120f may comprise a silicon interconnect bridge that provides electrical connections between the IC dies 120a, 12b and the memory dies 121a-f that are adjacent to each other on the substrate 102. The bridge dies 112a-112f are embedded within the substrate 102.

Dummy die 118a extends stress region 117a a distance 127a, beyond edges of the bridge die 112a. In an embodiment, dummy die 118b extends stress region 117b a distance 127b beyond edges of the bridge die 112f. The stress regions 117a, 117b may be any shape and the distances 127a, 127c may vary according to the particular architectural design requirements. By placing the dummy dies 118a, 118b adjacent to the edges of the IC dies 120a, 120b, the reliability of the bridge dies 112a, 112f is improved, and cracking of the bridge dies 112a, 112f is avoided.

An underfill material 113 (as shown in FIGS. 1A-1B) may be between and on top surfaces of the dummy dies 118a, b and may be between and on top surfaces of the IC dies 12a-120d. The underfill material 113 may comprise an epoxy material in an embodiment.

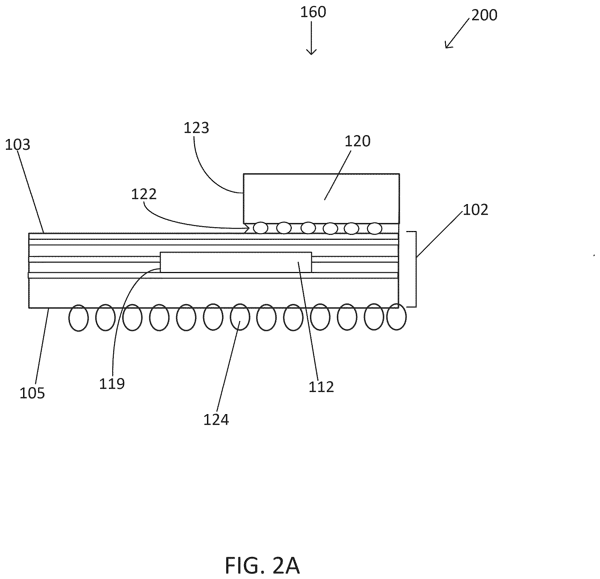

FIGS. 2A-2C depict methods of forming a multichip package structure according to embodiments, such as those depicted in FIGS. 1A- 1E for example. FIG. 2A depicts a cross-sectional view of a portion of a package structure 200 in an embodiment. In an embodiment, the portion of the package structure 200 may be received using process 160 which comprises a substrate 102, which may comprise a wafer or a panel substrate. In an embodiment, the substrate 102 may comprise dielectric material interspersed with conductive material. In an embodiment, a bridge structure 112 may be embedded within the substrate 102. The bridge structure 112 may comprise a silicon or a glass material in an embodiment. The substrate 102 may comprise a first side 103 and a second side 105.

An IC die 120 may be on the first side of the substrate 102. The IC die 120 may comprise any suitable type of device, such as CPU, logic dies, etc. The IC die 120 may be attached to the substrate 102 using any suitable die attach process as is known in the art. The IC die 120 may be coupled to the substrate 102 by conductive bumps 122, such as C4 bumps in an embodiment. The conductive bumps 122 may comprise micro-bumps in another embodiment. A second side 105 of the substrate 102 may comprise solder structures 124 which may be used to couple to another substrate, such as a board or printed circuit board (PCB). In an embodiment, an edge 119 of the bridge die 112 may extend beyond an edge 123 of the IC die 120. Because the edge 119 of the bridge die 112 extends beyond the edge 123 of the IC die 120, the bridge die 112 becomes susceptible to stress damage, such as cracks or fractures which may lead to failure of the bridge die 112, which negatively impacts reliability and yield for the package structure 200.

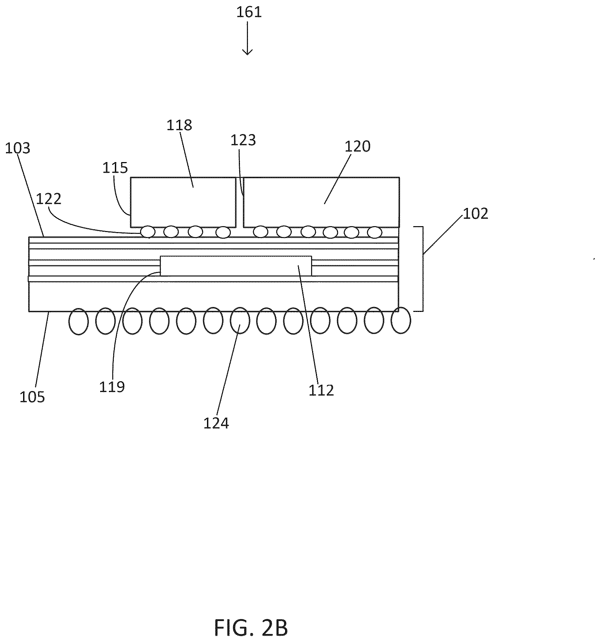

FIG. 2B depicts a process 161 wherein a dummy die 112 is attached onto the first side 103 of the substrate 102 adjacent to the IC die 120. Any suitable die attach process may be utilized to attach the dummy die 118 to the substrate 102, as are known in the art. In an embodiment, the dummy die 118 may be attached to the substrate 102 by conductive bumps 122, such as C4 bumps in an embodiment, however any suitable conductive structures maybe used to attach the dummy die to the first side 103 of the substrate 102. The dummy die 118 may comprise a non-functional structure to be used to alleviate stress in the bridge die 112 embedded within the substrate 102.

The placement of the dummy die 118 may be optimized to reduce a stress that may be induced within the embedded bridge die 112 due to a CTE mismatch between the bridge die 112 material and an underfill material to be formed over the IC die. In an embodiment, the dummy die 118 may be placed adjacent any number of IC dies 120 as is necessary when the bridge die 112 edge 119 extends beyond an edge 123of the IC die 120, so that the edge 115 of the dummy die 118 extends past the edge 119 of the bridge die 112.

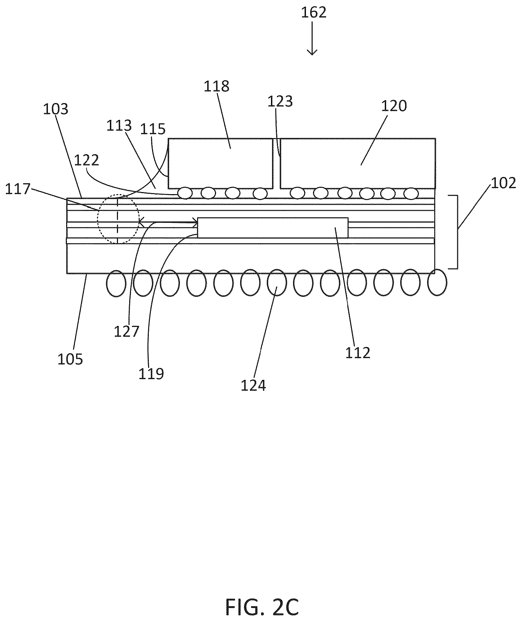

FIG. 2C depicts a process 162 comprising an overmold process. In an embodiment, an encapsulant/underfill material 113, such as an epoxy material for example, is formed between the IC die 120 and the dummy die 118 as well as top on surfaces of the IC die 120 and the top surfaces of the dummy die 118. In an embodiment, the underfill material 113 may be on sidewalls of the dummy die 118 and may extend past the sidewall/edge 115 of the dummy die 118. The underfill material 113 fills any gaps between IC die 120 and dummy die 118. In an embodiment, once the underfill material 113 is placed between and on the IC die 120 and the dummy die 118 the underfill material 113 may be cured and then may undergo a grinding process.

There may be a difference between a CTE of the underfill material 113 and a CTE of the bridge die 112 material. For example, a CTE for an epoxy material may range from about 53-57 ppm per degrees Celsius, and a CTE of a silicon material may be about 2.1-2.3 ppm per degrees Celsius. Thus, the difference between the CTE's of the bridge die 112 material and the underfill material 113 may be sufficient to cause failure in the bridge material 112. By placing the dummy die 112 on the first side 103 of the substrate 102 such that the edge 115 of the dummy die 118 extends beyond the edge 119 of the bridge die 112, a stress region 117 may be extended a distance 127 away from the edge 119 of the bridge die 112. By extending the stress region 117 away from the bridge die 112, stress damage such as fracturing or cracking of the bridge die 112 is be avoided.

FIG. 3 depicts an IC package structure 300, such as a multi-chip package structure 300, which may be similar to the portions of the package structures depicted in FIGS. 1A-1E for example. The multi-chip package structure 300 comprises an IC die 120 coupled to a first side 303 of the substrate 344 through interconnect structures 122. In an embodiment, the IC die 120 may comprise any functionality, such as a silicon IC die, a memory IC, or a central processing unit (CPU) IC die for example. The IC die 120 may be located in any position on the first side 303 of package substrate 344.

A bridge die 112 may be coupled to the IC die 120 through bridge interconnect structures 313. Die interconnect structures 314 may couple the die 120 to a core 320. In an embodiment, the die interconnect structures 314 may comprise a larger diameter than a diameter of the bridge interconnect structures 313. In an embodiment, the bridge interconnect structures 313 may comprise conductive bumps, or may be any other type of electrical connection structures such as balls, pins, pads, wire bonding, etc. In an embodiment, die interconnect structures 314 which are adjacent to the bridge interconnect structures 313 are not coupled to the bridge die 112. In an embodiment, a diameter of the bridge interconnect structures 313 may be the same as a diameter of the die interconnect structures 314, or the diameter of the bridge interconnect structures 313 may be different than the diameter of the die interconnect structures 314.

In an embodiment, an underfill material 113 may at least partially surround the IC die 120 and may additionally surround a dummy die 118. The dummy die 118 is adjacent to the IC die 120 on the first side 303 of the substrate 344. The dummy die 118 may comprise silicon for example.

In an embodiment, the dummy die 118 may be placed adjacent any number of IC dies 120 as is necessary when the bridge die 112 edge 119 extends beyond an edge 123 of the IC die 120, so that an edge 115 of the dummy die 118 extends past the edge 119 of the bridge die 112. The placement of the dummy die 118 extends a stress region 117 a distance 127 beyond the edge 119 of the bridge die 112, thus avoiding stress failures in the bridge die 112.

The substrate 344 may comprise a core 320 with a first build up layer 317a and a second build up layer 317b on either side of the core 320. Buildup layers 317a, 317b may comprise a multiple-layer stack of overlaid sheets of laminated film (e.g., buildup film). Buildup layers 317a, 317b materials may include composite epoxies, liquid crystalline polymers and polyimides. Other suitable materials may be employed. In some embodiments, buildup layers 317a, 317b are a monolithic block rather than laminated film. Suitable organic or inorganic materials may be employed. Buildup layers 317a, 317b may include such materials as FR4 (e.g., epoxy-based laminate), bismaleimide-triaxine, polyimide, silicon, or epoxy resin. buildup layers 317a, 317b may comprise organic buildup film or any other dielectric material suitable for electrical packaging.

The buildup layers 317a, 317b may form a structure with a desired thickness. In an embodiment, the buildup layers 317a, 317b may comprise electrically conductive features (e.g., pads, traces, vias, etc.) that are fabricated in conjunction with the formation of the buildup layers 317a, 317b. The conductive traces located throughout which may couple another substrate or die and may comprise copper or copper alloys in an embodiment.

The core 320 may comprise any suitable materials such as glass or dielectric materials in an embodiment. In an embodiment, the IC die 120 may comprise one of a chiplet structure which may comprise components of a system on a chip (SOC) structure that may be coupled to the core 320. Any number of die/devices may be coupled to the package substrate 344. The package substrate 344 and the device(s) 120 may be coupled to a board 345, such as a printed circuit board, in an embodiment. The board 345 may be coupled to the package substrate 344 through solder structures 349 that are located on a second side 305 of the substrate in an embodiment.

A power supply 343, which may comprise any suitable power supply as known in the art, may be coupled to IC die 120 via IC package substrate 344, in an embodiment. The circuit board 345 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board. In other examples, the circuit board may be a non-PCB substrate.

In some examples, the IC package 300 structure includes additional passive components, such as surface-mount resistors, capacitors, and/or inductors surfaces of the package substrate 344. While the package structure 300 describes an example of an architecture that may be employed according to the embodiments described herein, any number of different package architectures may be employed with the described embodiments, some of which are included within the embodiments described above.

Discussion now turns to operations for assembling and/or fabricating the discussed structures.

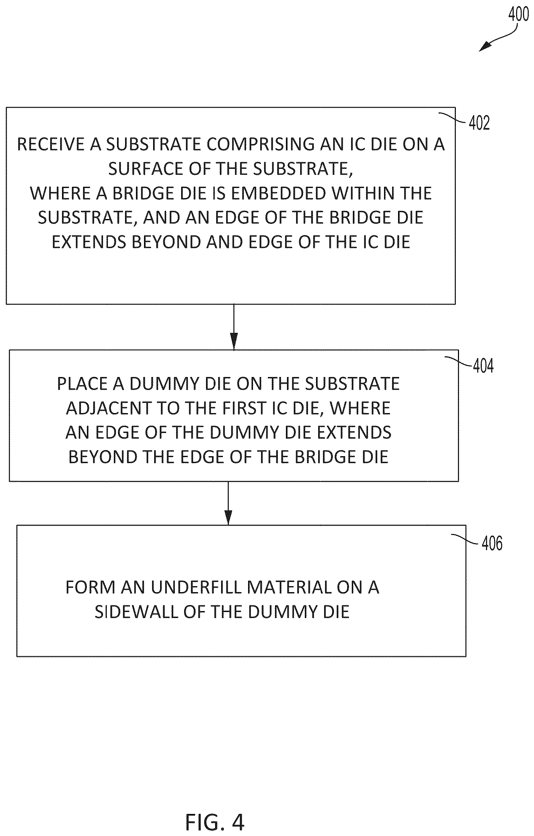

FIG. 4 is a flow chart of a process 400 of fabricating package structures, such as a disaggregated package structure comprising a bridge die shield, such as a dummy die to prevent stress failure in an embedded bridge die. For example, process 400 may be used to fabricate any of the microelectronic IC package structures of FIGS. 1A-1E, for example.

As set forth in block 402, a substrate may be received comprising an IC die on the substrate, wherein a bridge die is embedded within the substrate and an edge of the bridge die extends beyond an edge of the IC die. The substrate may include metal interconnects and vias, including but not limited to through-silicon vias (TSVs. The substrate may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices. In an embodiment, the substrate may include multiple metal layers separated from one another by layers of dielectric material and interconnected by electrically conductive vias. In some examples, the substrate may be formed of an epoxy resin, a fiberglass-reinforced epoxy resin, an epoxy resin with inorganic fillers, a ceramic material, or a polymer material such as polyimide. In some examples, the substrate may be formed of alternate rigid or flexible materials that may include the same materials described above for use in a semiconductor substrate, such as silicon, germanium, and other group III-V and group IV materials.

In an embodiment, the IC die may comprise a silicon chip or chiplets. In an embodiment, the IC die may comprise a central processing unit (CPU) or a field programmable gate array (FPGA) die, for example or may comprise any suitable logic die for a particular application. In an embodiment, the IC die may be attached to the substrate with C4 or micro bump die attach process with mass reflow or thermal-compression bonding (TCB). Alternately, the IC die may be attached with a surface mount process. In an embodiment, a dummy die is coplanar with second sides of the of two or more second IC dies. In an embodiment, the two or more second IC dies may comprise different functionalities/process flows, such as BEOL, RDL, Cu block, TMV etc. In an embodiment, the two or more second IC dies may be placed adjacent to each other in an intermediate layer between the first IC dies and the substrate.

The IC die may be attached utilizing any suitable die attach process, as are known in the art. The IC die can provide any suitable type of functionality (e.g., data processing, memory storage, etc.). The IC die is electrically and mechanically coupled directly to the substrate via corresponding arrays of conductive interconnects. In an embodiment, the conductive interconnects may comprise conductive bumps. However, the interconnects may be any other type of electrical connection in addition to or instead of the bumps shown (e.g., balls, pins, pads, wire bonding, etc.). In an embodiment, the IC die may be attached to the substrate with C4 or micro bump die attach process with mass reflow or thermal-compression bonding (TCB). Alternately the IC die may be attached with a surface mount process.

The bridge die may be embedded within the substrate. The bridge die may comprise an embedded interconnect bridge die in an embodiment. In an embodiment, the bridge die may comprise high density die-to-die interconnect structures with or without vertical through silicon vias (TSVs) to include power delivery or signal interconnect to the substrate. The bridge die may be coupled to the IC die with conductive bridge bumps. In an embodiment, the conductive bridge bumps are bumps on the bridge die through which electrical signals pass between the bridge die and the IC die. In an embodiment, the IC die may comprise core bumps that are adjacent to the bridge bumps, wherein core bumps may be larger than bridge bumps. The core bumps connect the IC die with a core within the substrate.

At step 404, a dummy die may be placed adjacent to the IC die, directly on the substrate. In an embodiment, any number of dummy dies may be placed adjacent to the IC die on the substrate. In an embodiment, the dummy die may comprise silicon blocks with a low coefficient of thermal expansion filler material to improve mechanical performance of the disaggregated package substrate. The dummy die may be placed on areas on the substrate which do not have IC dies. In an embodiment, the IC die and the dummy die may be attached onto a wafer or a panel carrier to create a reconstituted wafer (or panel) with IC die pads or bumps exposed.

In an embodiment, surfaces of the dummy die and the IC die may be placed onto a substrate, such as a ball grid array substrate. In an embodiment, the substrate may comprise a core, such as a silicon or a glass core. In other embodiments, the substrate may be a coreless substrate. In some embodiments, the substrate may comprise organic material. In some embodiments, the substrate may comprise build-up layers on a first and a second side of a core. In an embodiment, the dummy die may comprise a bridge shield chiplet that is placed to extend a high stress point beyond a bridge die shadow. In an embodiment, an edge of the dummy die extends beyond the edge of the bridge die.

At step 406, an underfill material is formed on a sidewall of the dummy die. In an embodiment, a first portion of the bridge die is below the device die and a second portion of the bridge die is below dummy die, and wherein the edge of the dummy die is beyond an edge of the bridge die. In an embodiment, the underfill material may comprise an epoxy or an epoxy-resin material, such as polymer composite material, such as an epoxy resin material with filler, epoxy acrylate with filler or a polymer with a filler. In an embodiment, the underfill material may comprise a non-conductive material which protects the IC die from environmental contaminants.

In another embodiment, a first die may be adjacent a second die, wherein the first and second IC dies are on a substrate. A bridge die may be embedded within the substrate between the first and second die, wherein the bridge die may be below the first and second die and may extend a portion beyond edges of the first and second die. A dummy die may be over the portions of the bridge die that extend beyond the edges of the first and second IC dies. The dummy die alleviates a stress point between the underfill material and the bridge die. In an embodiment, the dummy die extends the stress point a distance from the edges of the two IC dies.

In another embodiment, four IC dies may be adjacent each other on a surface of a substrate. A first bridge die may be in a center portion between the four IC dies, wherein the bridge die is coupled to each of the four IC dies. A second bridge die may be on an edge portion of two of the four IC dies, wherein the second bridge die extends beyond the edges of the two IC dies coupled to the second bridge die. A dummy die is over the second bridge die, wherein the dummy die alleviates a stress point between the underfill material and the second bridge die. In an embodiment, the second dummy die extends the stress point a distance from the edges of the two IC dies.

The embodiments herein enable a bridge die shield structure, wherein an edge of a dummy die extends beyond an edge of a bridge die to avoid stress damage in the bridge die.

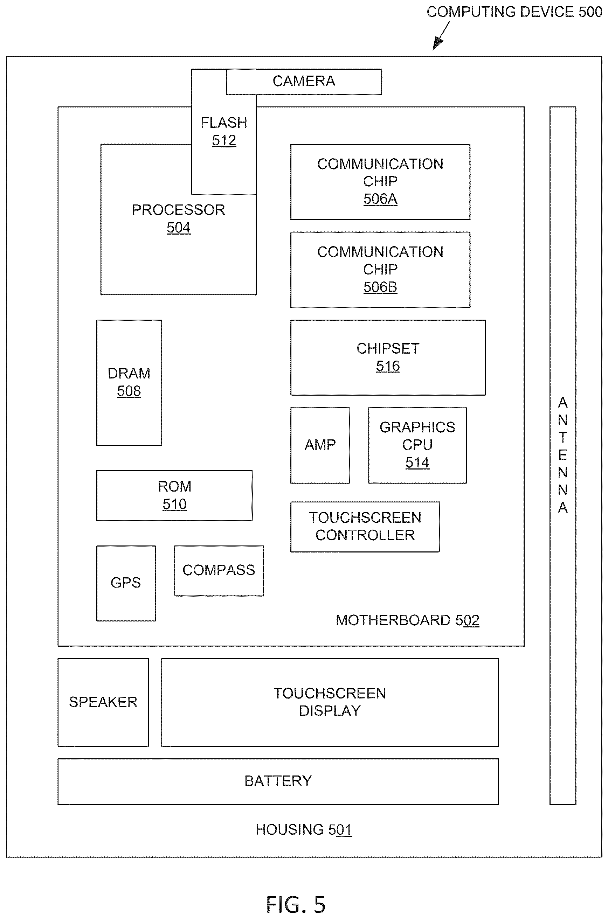

FIG. 5 illustrates an electronic or computing device 500 in accordance with one or more implementations of the present description. The computing device 500 may include a housing 501 having a board 502 disposed therein. The computing device 500 may include a number of integrated circuit components, including but not limited to a processor 504, at least one communication chip 506A, 506B, volatile memory 508 (e.g., DRAM), non-volatile memory 510 (e.g., ROM), flash memory 512, a graphics processor or CPU 514, a digital signal processor (not shown), a crypto processor (not shown), a chipset 516, an antenna, a display (touchscreen display), a touchscreen controller, a battery, an audio codec (not shown), a video codec (not shown), a power amplifier (AMP), a global positioning system (GPS) device, a compass, an accelerometer (not shown), a gyroscope (not shown), a speaker, a camera, and a mass storage device (not shown) (such as hard disk drive, compact disk (CD), digital versatile disk (DVD), and so forth). Any of the integrated circuit components may be physically and electrically coupled to the board 502. In some implementations, at least one of the integrated circuit components may be a part of the processor 504.

The communication chip enables wireless communications for the transfer of data to and from the computing device. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

The term "processor" may refer to any device or portion of a device that processes electronic data from registers and/or memory to transform that electronic data into other electronic data that may be stored in registers and/or memory. At least one of the integrated circuit components may include an IC die and a dummy die on a substrate, and a bridge die below the device die, wherein an edge of the dummy die is beyond an edge of the bridge die, and an edge of the bridge die is beyond an edge of the IC die.

In various implementations, the computing device may be a laptop, a netbook, a notebook, an ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device may be any other electronic device that processes data.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure. It is understood that the subject matter of the present description is not necessarily limited to specific applications illustrated in FIGS. 1-5. The subject matter may be applied to other integrated circuit devices and assembly applications, as well as any appropriate electronic application, as will be understood to those skilled in the art.

The following examples pertain to further embodiments and specifics wherein the examples may be used anywhere in one or more embodiments wherein a first example is an apparatus, comprising: a substrate comprising a first side and a second side opposite the first side; a dummy die comprising a first edge and a second edge, wherein the dummy die is on the first side of the substrate; a device die on the first side of the substrate, adjacent to the first edge of the dummy die; and a bridge die, wherein a first portion of the bridge die is below the device die and a second portion of the bridge die is below dummy die, and wherein the second edge of the dummy die is beyond an edge of the bridge die.

In second examples, wherein the first example further comprises wherein a distance of not less than 0.5 microns is between the edge of the bridge die and the second edge of the dummy die.

In third examples, wherein the second example further comprises wherein a stress region in the substrate beyond the distance is greater than 10 times a stress at the edge of the bridge die.

In fourth examples, wherein any of examples 1-3 further comprise wherein the stress region is beyond the second edge of the dummy die.

In fifth examples, wherein any of examples 1-4 further comprise wherein the dummy die is electrically isolated from the bridge die.

In sixth examples, wherein any of examples 1-5 further comprise wherein the device die comprises a first IC die, and wherein a second IC die is adjacent the first IC die, wherein the first IC die and the second IC die are coupled to the bridge die, wherein the edge of the bridge die extends beyond an edge of the first IC die and extends beyond an edge of the second IC die.

In seventh examples, wherein example 6 further comprise wherein the edge of the first IC die and the edge of the second IC die are perpendicular to each other.

In eighth examples, wherein examples 7 further comprises wherein the edge of the first IC die and the edge of the second IC die are parallel to each other..

In ninth examples, wherein any of examples 1-8 further comprise wherein an underfill material on the dummy die comprises a coefficient of thermal expansion (CTE) that is greater than 20% of a CTE of the bridge die.

In tenth examples, wherein any of examples 1-9 further wherein the underfill material extends beyond the second edge of the dummy die.

In eleventh examples, wherein any of examples 10 further comprises wherein a power supply is coupled to the device die.

Example 12 is an apparatus comprising a substrate; a dummy die comprising a first edge and a second edge, wherein the dummy die is on a surface of the substrate; a device die adjacent to the second edge of the dummy die; an underfill material on the first edge of the dummy die; and a bridge die comprising a first bridge edge and a second bridge edge, wherein a distance is between the first bridge edge and the first edge of the dummy die.

In thirteenth examples, wherein examples 12 further comprises wherein the second bridge edge is below the device die, and the first bridge edge extends beyond the device die.

In fourteenth examples, wherein any of examples 12-13 further comprise wherein the underfill material comprises an epoxy material and comprises a CTE that is greater than 20 percent of a CTE of the bridge die.

In fifteenth examples, wherein any of examples 12-14 further comprise wherein the bridge die comprises a thickness of between 30 microns and 60 microns.

In sixteenth examples, wherein any of examples 12-15 further comprise wherein the device die comprises a first IC die, and wherein the first IC die, a second IC die, a third IC die and a fourth IC die are coupled to an additional bridge die, and wherein the bridge die is coupled the first IC die and the second IC die, wherein the first bridge edge extends beyond the first IC die and the second IC die.

Example 17 is a method comprising receiving a substrate comprising an IC die on a surface of the substrate, wherein a first edge of a bridge die is below a portion of the IC die, wherein the bridge die is coupled to the IC die; placing a dummy die adjacent to the IC die, wherein the second edge of the bridge die is below the dummy die; and forming an underfill material on a sidewall of the dummy die.

In eighteenth examples, wherein example 17 further comprises wherein the second edge of the bridge die extends beyond an edge of the IC die.

In nineteenth examples, wherein any of examples 17-18 further comprise wherein the bridge die comprises a silicon material or a glass material.

In twentieth examples, wherein any of examples 17-19 further comprise wherein a difference between a CTE of the underfill material and a CTE of the dummy die is greater than about 20 ppm/degrees Celsius.

It will be recognized that principles of the disclosure are not limited to the embodiments so described but can be practiced with modification and alteration without departing from the scope of the appended claims. The above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

## Claims

1. An apparatus, comprising:
a substrate comprising a first side and a second side opposite the first side;
a dummy die comprising a first edge and a second edge, wherein the dummy die is on the first side of the substrate;
a device die on the first side of the substrate, adjacent to the first edge of the dummy die; and
a bridge die, wherein a first portion of the bridge die is below the device die and a second portion of the bridge die is below dummy die, and wherein the second edge of the dummy die is beyond an edge of the bridge die.

2. The apparatus of claim 1, wherein a distance of not less than 0.5 microns is between the edge of the bridge die and the second edge of the dummy die.

3. The apparatus of claim 2, wherein a stress region in the substrate beyond the distance is greater than 10 times a stress at the edge of the bridge die.

4. The apparatus of claim 3, wherein the stress region is beyond the second edge of the dummy die.

5. The apparatus of any one of claims 1 to 4, wherein the dummy die is electrically isolated from the bridge die.

6. The apparatus of any one of claims 1 to 5, wherein the device die comprises a first IC die, and wherein a second IC die is adjacent the first IC die, wherein the first IC die and the second IC die are coupled to the bridge die, wherein the edge of the bridge die extends beyond an edge of the first IC die and extends beyond an edge of the second IC die.

7. The apparatus of claim 6, wherein the edge of the first IC die and the edge of the second IC die are perpendicular to each other.

8. The apparatus of claim 6, wherein the edge of the first IC die and the edge of the second IC die are parallel to each other.

9. The apparatus of any one of claims 1 to 8, wherein an underfill material on the dummy die comprises a coefficient of thermal expansion (CTE) that is greater than 20% of a CTE of the bridge die.

10. The apparatus of claim 9, wherein the underfill material extends beyond the second edge of the dummy die.

11. The apparatus of any one of claims 1 to 10, wherein a power supply is coupled to the device die.

12. A method, comprising:
receiving a substrate comprising an IC die on a surface of the substrate, wherein a first edge of a bridge die is below a portion of the IC die, wherein the bridge die is coupled to the IC die;
placing a dummy die adjacent to the IC die, wherein a second edge of the bridge die is below the dummy die; and
forming an underfill material on a sidewall of the dummy die.

13. The method of claim 12, wherein the second edge of the bridge die extends beyond an edge of the IC die.

14. The method of claim 13, wherein the bridge die comprises a silicon material or a glass material.

15. The method of any one of claims 12 to 14, wherein a difference between a CTE of the underfill material and a CTE of the dummy die is greater than about 20 ppm/degrees Celsius.
